# EUROPÄISCHE PATENTANMELDUNG

(11) **EP 1 063 773 A2**
(43) Veröffentlichungstag der Anmeldung: **27.12.2000**
(21) Anmeldenummer: 00112344.7
(22) Anmeldetag: 09.06.2000
(51) Int. Cl.: H03K 17/97

(54) **Sicherheitssensor**

(30) Priorität: 23.06.1999 DE 19928641
(71) Anmelder: K.A. SCHMERSAL GmbH & Co., D-42279 Wuppertal (DE)
(72) Erfinder: Hoepken, Hermann, 45549 Sprockhövel (DE); Kampmeier, Stefan, 58256 Ennepetal (DE); Stratmann, Christoph, 45277 Essen (DE)
(74) Vertreter: Sparing - Röhl - Henseler Patentanwälte

(57) **Zusammenfassung**

Die Erfindung betrifft einen Sicherheitssensor zur Überwachung der Position von zwei relativ zueinander beweglichen Bauteilen (2, 4) einer Zugangsschutzeinrichtung für eine Maschine oder maschinelle Anlage, deren Abschaltung und Einschaltbarkeit über eine Steuerung (10) steuerbar ist, wobei der Sicherheitssensor eine von einem Bauteil (2) aufzunehmende Sensoreinheit (1), die eine an einen Auswertekreis (14) angeschlossene Spulenanordnung (11) zum Senden und Empfangen eines hochfrequenten Signals sowie einen magnetisch auslösbaren Sensor (5) umfaßt, und einen einen Magneten (6) sowie einen Antwortsender (12) zum vorbestimmten Modifizieren des von der Spulenanordnung (11) ausgesandten Signals umfassenden, vom anderen Bauteil (4) aufzunehmenden Auslöser (3) aufweist. Hierbei weist die Sensoreinheit (1) zwei parallele Kanäle auf, von denen derjenige, der den magnetisch auslösbaren Sensor (5) umfaßt, bei unausgelöstem Sensor (5) ein Abschaltsignal liefert, und der andere, der die Spulenanordnung (11) enthält, bei Erkennung des vom Antwortsender (12) modifizierten Signals durch den Auswertekreis (14) ein Freigabesignal für die Einschaltbarkeit liefert.

## Beschreibung

Die Erfindung betrifft einen Sicherheitssensor nach dem Oberbegriff des Anspruchs 1.

Bei Sicherheitssensoren und -schaltern zur Überwachung der Position von zwei relativ zueinander beweglichen Bauteilen einer Schutzeinrichtung bezüglich des Zugangs zu einer Maschine oder maschinellen Anlage, deren Abschaltung und Einschaltbarkeit über eine die Ausgangssignale der Sicherheitssensoren und - schalter auswertenden Steuerung steuerbar ist, handelt es sich um Sicherheits-Bauteile, die nicht in einfacher Weise etwa durch ein einfaches Werkzeug und/oder eine einfache Manipulation überlistet werden können, um den geschlossenen Zustand der relativ zueinander beweglichen Bauteile vorzutäuschen, etwa um (unerlaubten und gefährdeten) Zugang zur laufenden Maschine zu bekommen.

Ein berührungsloser Sicherheitsschalter ist aus der deutschen Patentanmeldung 198 40 620.7 bekannt, bei dem eine Schaltereinheit einen Sendekreis mit einer Sendespule für ein Hochfrequenzsignal und einen Empfangskreis mit einer Emfangsspule sowie einen magnetisch auslösbaren Hallsensor umfaßt, während der Auslöser einen Magneten zur Auslösung des Hallsensors als auch eine Auslöserspule gegebenenfalls mit einer Einrichtung zum Modifizieren des von der Sendespule empfangenen Signals etwa durch Frequenzteilung umfaßt. Dieser Sicherheitsschalter schaltet einen Freigabepfad frei, wenn bei durch den Magneten aktiviertem Hallsensor die Empfangsspule des Empfangskreises ein vorbestimmtes Signal von der Auslöserspute empfängt. Ein derartiger Sicherheitsschalter bietet jedoch für manche Anwendungszwecke keine genügende Diversität und Sicherheit.

Aus dem Prospekt "Berührungsloser Sicherheitsschalter CES" der Fa. Euchner GmbH + Co., Leinfelden-Echterdingen aus dem Jahre 1998 ist ein Sicherheitssensor bekannt, der einen Lesekopf als Sensoreinheit für einen kodierten Antwortsender (Transponder) umfaßt, der an einer Tür befestigt wird, während der Lesekopf an dem feststehenden Teil einer Schutzeinrichtung angebracht wird, so daß bei Erreichen des Einschaltabstandes die Spannungsversorgung zum Antwortsender und die Datenübertragung der vom Antwortsender gelesenen Daten erfolgen kann. Hierbei wird das vom Lesekopf empfangene Signal von zwei Mikroprozessoren verarbeitet, um so eine gewisse Redundanz in der Auswertung zu erzielen. Jedoch wird sensorseitig nur einkanalig gearbeitet und damit für bestimmte Anwendungszwecke nicht den geforderten Sicherheitsanforderungen genügt.

Aufgabe der Erfindung ist es, einen Sicherheitssensor nach dem Oberbegriff des Anspruchs 1 zu schaffen, der bei genügender Diversität eine erhöhte Sicherheit bewirkt.

Diese Aufgabe wird entsprechend dem kennzeichnenden Teil des Anspruchs 1 gelöst.

Dadurch, daß eine Sensoreinheit mit zwei parallelen Kanäle verwendet wird, von denen einer einen magnetisch auslösbaren Sensor umfaßt und bei unausgelöstem Sensor ein Abschaltsignal liefert, und der andere, der eine Spulenanordnung zum Senden und Empfangen eines hochfrequenten Signals enthält, das von einem Antwortsender modifiziert wird, wobei bei Erkennung des vom Antwortsender modifizierten Signals durch einen Auswertekreis ein Freigabesignal für die Einschaltbarkeit geliefert wird, wird einerseits die Sicherheit durch die Zweikanaligkeit und die Nutzung unterschiedlicher physikalischer Effekte in den beiden Kanälen erhöht und ist andererseits die Diversität wegen der Vielfalt der Möglichkeiten der Signalmodifizierung sehr groß.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt schematisch ein Blockschaltbild einer Ausführungsform eines Sicherheitssensors.
Fig. 2 zeigt schematisch ein Blockschaltbild einer weiteren Ausführungsform eines Sicherheitssensors.

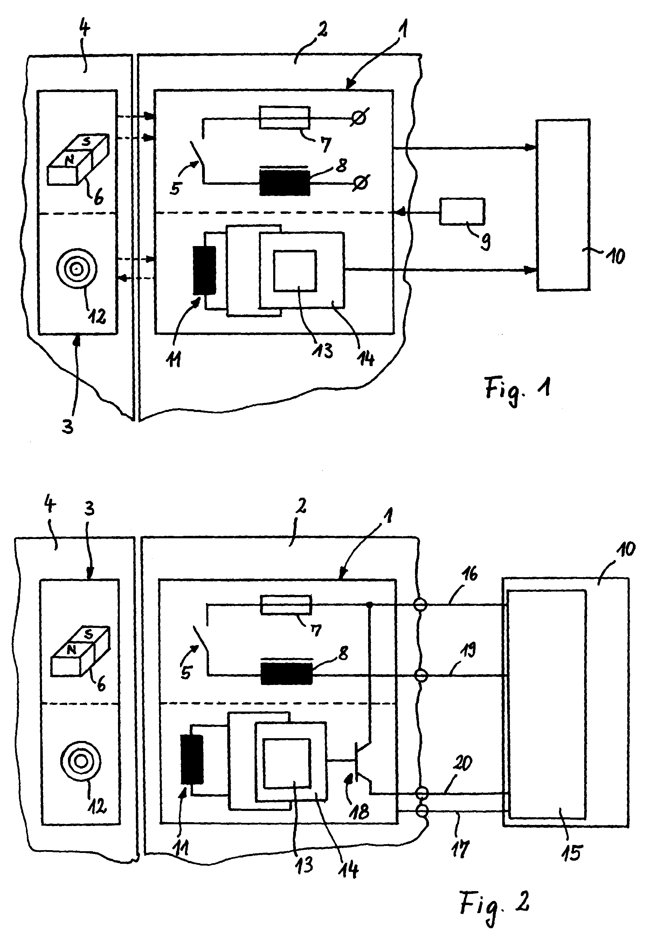

Der in Fig. 1 dargestellte Sicherheitsensor umfaßt eine Sensoreinheit 1, die an einem Bauteil 2, etwa einer feststehenden Wandung eines Maschinengehäuses, einer Maschinenumzäunung od.dgl., die eine Zugangsschutzeinrichtung bildet, angeordnet ist, sowie einen Auslöser 3, der beispielsweise an einem gegenüber dem Bauteil 2 beweglichen Bauteil 4, etwa an einer Tür, Klappe od.dgl. zum Versperren des Zugangs zu einer in dem Maschinengehäuse befindlichen Maschine oder maschinellen Anlage angeordnet ist.

Die Sensoreinheit 1 umfaßt zwei Kanäle, die unterschiedliche physikalische Prinzipen zur Überwachung der Position der Bauteile 2, 4 nutzen. So besitzt die Sensoreinheit 1 einen ersten Kanal, der wenigstens einen Reedkontakt 5 umfaßt, der von einem Schaltmagneten 6 des Auslösers 3 betätigbar ist. Zweckmäßigerweise ist dabei der Reedkontakt 5 in Reihe mit einer schnellen Sicherung 7, die ein Verschweißen des Reedkontaktes 5 verhindert, und/oder einer Drossel 8 geschaltet, die zur Kompensation etwaiger Leitungskapazitäten dient.

Der Reedkontakt 5 wird hierbei zum sicherheitsrelevanten Abschalten, d.h. zum Schutz des Anwenders, verwendet, indem durch Öffnen des Reedkontaktes 5 durch Bewegen des beweglichen Bauteils 4 gegenüber dem feststehenden Bauteil 2 und durch Öffnen des Zugangs zum geschützten Raum ein Abschalten der in dem geschützten Raum befindlichen Maschine bzw. maschinellen Anlage erfolgt.

Die Sensoreinheit 1 ist einerseits an ein gegebenenfalls weitere Sicherheitssensoren oder -schalter stromversorgendes Gleichstrom-Netzteil 9 zwecks Stromversorgung und andererseits an eine externe, auf die Ausgangssignale der beiden Kanäle der Sensoreinheit 1 ansprechende Steuerung 10 angeschlossen. Letztere bewirkt beim Öffnen des Reedkontaktes 5 das sicherheitsrelevante Abschalten der geschützten Maschine oder maschinellen Anlage.

Die Sensoreinheit 1 besitzt einen zweiten, an die Steuerung 10 angeschlossenen, von dem Gleichstrom-Netzteil 9 stromversorgten Kanal, der eine Spulenanordnung 11 zum Senden und Empfangen eines hochfrequenten Trägersignals, die mit einem entsprechenden Taktsignalgenerator (nicht dargestellt) gekoppelt ist, umfaßt. Die Spulenanordnung 11 wirkt mit einem Antwortsender 12 des Auslösers 3 zusammen, indem der Antwortsender 12 dem von der Spulenanordnung 11 in der geschlossenen Position der Bauteile 2, 4 empfangenen Trägersignal ein einprogrammiertes Signal, etwa eine einprogrammierte Zahl, ein TAG-Datum, aufmoduliert und dieses so in vorbestimmter Weise modulierte Signal an die Spulenanordnung 11 zurücksendet, die an einen beispielsweise einen Mikroprozessor 13 umfassenden Auswertekreis 14 angeschlossen ist, die das dem Trägersignal durch den Antwortsender 12 aufmodulierte Signal demodulieren kann. Das so durch Demodulation gewonnene Signal kann etwa über eine serielle Schnittstelle an die Steuerung 10 zur Verarbeitung geliefert werden. Wenn das demodulierte Signal mit dem erwarteten Signal übereinstimmt, wird ein entsprechendes Freigabesignal ausgegeben, und wenn gleichzeitig der Reedkontakt 5 geschlossen ist und ein dementsprechendes Signal an der Steuerung 10 anliegt, wird das Einschalten der in dem geschützten Raum befindlichen Maschine bzw. maschinellen Anlage, insoweit es diesen Sicherheitssensor betrifft und andere Sicherheitssensoren dies nicht weiterhin sperren, durch die Steuerung 10 freigegeben.

Bei der in Fig. 2 dargestellten Ausführungsform umfaßt die Steuerung 10 einen Sicherheitsbaustein 15 (etwa der Sicherheitskategorie 4), der beispielsweise über einen Sicherheitsbus mit einer zentralen Steuereinheit verbunden ist und der die Sensoreinheit 1 über Leitungen 16, 17 mit Gleichstrom versorgt. Das von der Auswerteeinheit 14 erzeugte Signal, das den Empfang des durch den Antwortsender 12 modulierten Signals bestätigt, wird hierbei mit einer abgespeicherten Identifizierungsnummer, ID-Datum, verglichen. Bei Übereinstimmung das TAG-Datums mit dem abgespeicherten ID-Datum wird zweckmäßigerweise ein Schalttransistor 18 (oder ein Thyristor oder Relaiskontakt) durchgeschaltet, so daß die auf den beiden zu dem Sicherheitsbaustein 15 führenden Leitungen 19, 20 anstehenden Signale von letzterem ausgewertet und weiterverarbeitet werden können.

Das abgespeicherte ID-Datum kann mit Hilfe eines Lern-Algorithmus individuell einprogrammiert werden.

Anstelle eines Reedkontaktes 5 läßt sich auch ein Hallsensor als magnetisch auslösbarer Sensor verwenden.

Anstelle der Modulation des Trägersignals mittels eines vorzugsweise einprogrammierten TAG-Datums kann auch eine andere Modifizierung des von der Spulenanordnung ausgesandten Trägersignals vorgenommen werden, etwa eine einprogrammierte Frequenzteilung oder -vervielfachung, wobei dann auch der Sensor 5 zum Programmieren entsprechend ausgebildet ist.

Der Antwortsender 12 kann auch einen Generator für variable Kodes enthalten, die einen Teil eines Identifikationskodes des Antwortsender 12 darstellen, der mit weiteren Bits moduliert ist, während die Sensoreinheit 1 aus dem vom Antwortsender 12 empfangenen Signal den in der Sensoreinheit 1 gespeicherten Identifikationskode herausfiltert. Der bitmodulierte Idenfikationskode kann zum zusätzlichen Modulieren des von der Sensoreinheit 1 ausgesandten Signals verwendet werden.

## Patentansprüche

1. Sicherheitssensor zur Überwachung der Position von zwei relativ zueinander beweglichen Bauteilen (2, 4) einer Zugangsschutzeinrichtung für eine Maschine oder maschinelle Anlage, deren Abschaltung und Einschaltbarkeit über eine Steuerung (10) steuerbar ist, wobei der Sicherheitssensor eine von einem Bauteil (2) aufzunehmende Sensoreinheit (1), die eine an einen Auswertekreis (14) angeschlossene Spulenanordnung (11) zum Senden und Empfangen eines hochfrequenten Signals sowie einen magnetisch auslösbaren Sensor (5) umfaßt, und einen einen Magneten (6) sowie einen Antwortsender (12) zum vorbestimmten Modifizieren des von der Spulenanordnung (11) ausgesandten Signals umfassenden, vom anderen Bauteil (4) aufzunehmenden Auslöser (3) aufweist, **dadurch gekennzeichnet**, daß die Sensoreinheit (1) zwei parallele Kanäle aufweist, von denen derjenige, der den magnetisch auslösbaren Sensor (5) umfaßt, bei unausgelöstem Sensor (5) ein Abschaltsignal liefert, und der andere, der die Spulenanordnung (11) enthält, bei Erkennung des vom Antwortsender (12) modifizierten Signals durch den Auswertekreis (14) ein Freigabesignal für die Einschaltbarkeit liefert.

2. Sicherheitssensor nach Anspruch 1, dadurch gekennzeichnet, daß der Antwortsender (12) ein Datensignal zum Modulieren des von der Spulenanordnung (11) ausgesandten Signals enthält, wobei das Datensignal durch den Auswertekreis (14) demodulierbar ist.

3. Sicherheitssensor nach Anspruch 2, dadurch gekennzeichnet, daß das Datensignal einprogrammierbar ist.

4. Sicherheitssensor nach Anspruch 2 oder 3, dadurch gekennzeichnet, daß das Datensignal mittels der Auswerteeinheit (14) mit einem Identifizierungssignal vergleichbar ist.

5. Sicherheitssensor nach Anspruch 4, dadurch gekennzeichnet, daß bei Übereinstimmung zwischen Datensignal und Identifizierungssignal ein Schalttransistor (18) durchschaltbar ist.

6. Sicherheitssensor nach einem der Ansprüche 1 bis 5, dadurch gekennzeichnet, daß der Auswertekreis (14) einen Mikroprozessor (13) umfaßt.

7. Sicherheitssensor nach einem der Ansprüche 1 bis 6, dadurch gekennzeichnet, daß die Spulenanordnung (11) eine Sende-/Empfangsspule umfaßt.

8. Sicherheitssensor nach einem der Ansprüche 1 bis 7, dadurch gekennzeichnet, daß der magnetisch auslösbare Sensor wenigstens einen von dem Magneten (6) betätigbaren Reedkontakt (5) umfaßt.

9. Sicherheitssensor nach einem der Ansprüche 1 bis 7, dadurch gekennzeichnet, daß der magnetisch auslösbare Sensor wenigstens einen von dem Magneten (6) betätigbaren Hallsensor umfaßt.

10. Sicherheitssensor nach einem der Ansprüche 1 bis 8, dadurch gekennzeichnet, daß der Antwortsender (12) einen Generator zum Erzeugen eines bitmodulierten Idenfikationskodes umfaßt.
